# EUROPEAN PATENT APPLICATION

(11) **EP 2 515 346 A1**
(43) Date of publication of application: **24.10.2012**
(21) Application number: 10837670.8
(22) Date of filing: 16.12.2010
(51) Int. Cl.: H01L 31/04, H01L 21/208

(54) **PROCESS FOR PRODUCING SEMICONDUCTOR LAYER, PROCESS FOR PRODUCING PHOTOELECTRIC CONVERTER, AND SOLUTION FOR FORMING SEMICONDUCTOR LAYER**

(30) Priority: 18.12.2009 JP 2009287744; 26.12.2009 JP 2009296482; 26.12.2009 JP 2009296483; 30.03.2010 JP 2010077379
(71) Applicant: Kyocera Corporation, Kyoto-shi Kyoto 612-8501 (JP)
(72) Inventor: INAI Seiichiro, Higashiomi-shi Shiga 527-8555 (JP); NISHIMURA Daisuke, Higashiomi-shi Shiga 527-8555 (JP); TANAKA Isamu, Higashiomi-shi Shiga 527-8555 (JP)
(74) Representative: Witte, Weller & Partner
(86) International application number: PCT/JP2010/072695
(87) International publication number: WO 2011/074645

(57) **Abstract**

It is an object of the present invention to provide a method for manufacturing a semiconductor layer, a method for manufacturing a photoelectric conversion device, and a semiconductor layer forming solution which are able to easily manufacture a good semiconductor layer having a desired thickness. To accomplish this object, a starting solution containing a metallic element, an organic compound containing a chalcogen element and a Lewis base organic compound is initially produced. Next, heating the starting solution produces fine particles. The fine particles contain a metal chalcogenide which is a compound of the metallic element and a chalcogen element included in the organic compound containing a chalcogen element. A semiconductor layer is formed by using a semiconductor layer forming solution in which the fine particles are dispersed.

## Description

### Technical Field

The present invention relates to a method for manufacturing a semiconductor layer, a method for manufacturing a photoelectric conversion device, and a semiconductor layer forming solution.

### Background Art

There are some solar cells which employ a photoelectric conversion device including a light-absorbing layer made of a group I-III-VI compound semiconductor. The group I-III-VI compound semiconductor is a chalcopyrite-based compound semiconductor such as CIGS. In this photoelectric conversion device, a first electrode made of, for example, Mo is formed on a substrate made of, for example, soda-lime glass, and the light-absorbing layer made of a group I-III-VI compound semiconductor is formed on this first electrode layer. Further, a buffer layer made of zinc sulfide, cadmium sulfide or the like is formed on the light-absorbing layer, and a transparent second electrode layer made of zinc oxide or the like is formed on the buffer layer.

The light-absorbing layer can be formed by using a device of a vacuum system for a sputtering method or the like. A method for forming a light-absorbing layer in which manufacturing costs are further reduced has been developed.

For example, Patent Literature 1 discloses a technique such that a solution prepared by dissolving a metal chalcogenide in hydrazine is applied onto an electrode layer provided on a substrate to form a precursor layer, and a heat treatment is performed on the precursor layer to form a compound semiconductor layer including a metal chalcogenide film.

### Prior Art Document

### Patent Literature

Patent Literature 1: Specification of U.S. Pat. No. 7,341,917

### Summary of Invention

### Problem to be Solved by the Invention

However, the solution (also referred to as a starting solution) prepared by dissolving a metal chalcogenide in hydrazine as disclosed in Patent Literature 1 has a metal chalcogenide concentration of as high as 1% by mass, and is low in viscosity. It is hence not easy to form a precursor layer having a thickness on the order of several micrometers substantially uniformly on an electrode layer by a simple and easy method such as a blade method using this starting solution.

To form a precursor layer having a desired thickness, a method is contemplated which repeats the application of the starting solution and the drying thereof a plurality of times to form the precursor layer comprised of multiple layers. However, the process steps of this method are complicated by the application performed the plurality of times. Further, the multiple layers constituting the precursor layer are different from each other in state during the heat treatment. As a result, there is a likelihood that stresses are induced in the precursor layer to cause cracks therein.

Therefore, a method for manufacturing a semiconductor layer, a method for manufacturing a photoelectric conversion device, and a semiconductor layer forming solution which are able to easily form a good semiconductor layer having a desired thickness have been desired.

### Means to Solve the Problem

To solve the aforementioned problem, a method for manufacturing a semiconductor layer according to a first aspect of the present invention comprises the steps of: (a) producing a starting solution containing a metallic element, an organic compound containing a chalcogen element, and a Lewis base organic compound; (b) producing fine particles containing a metal chalcogenide which is a compound of the metallic element and a chalcogen element included in the organic compound containing a chalcogen element by heating the starting solution; and (c) forming a semiconductor layer by using a semiconductor layer forming solution in which the fine particles are dispersed.

A method for manufacturing a photoelectric conversion device according to a second aspect of the present invention comprises the steps of: (A) forming a second layer on a first layer; and (B) forming a third layer on the second layer, wherein a semiconductor layer included in the second layer is formed in the step (A) by a method for producing a semiconductor layer as recited in the first aspect, wherein the first layer includes a first electrode section, and wherein the third layer includes a second electrode section.

A semiconductor layer forming solution according to a third aspect of the present invention comprises a metallic element, an organic compound containing a chalcogen element, and a Lewis base organic compound, the semiconductor layer forming solution further comprising fine particles containing a metal chalcogenide which is a compound of the metallic element and a chalcogen element included in the organic compound containing a chalcogen element, the fine particles being dispersed in the semiconductor layer forming solution.

### Advantageous Effects of Invention

According to the aforementioned aspects of the present invention, a good semiconductor layer having a desired thickness is easily formed.

### Brief Description of Drawings

[Fig. 1] Fig. 1 is a perspective view illustrating a photoelectric conversion module according to one embodiment.
[Fig. 2] Fig. 2 is a view illustrating a cross-section of the photoelectric conversion module according to the one embodiment.
[Fig. 3] Fig. 3 is a graph illustrating a relationship between a heating temperature and an average particle diameter of fine particles.

### Embodiments for Carrying Out the Invention

One embodiment according to the present invention will be described with reference to the drawings.

### <(1) Configuration of Photoelectric Conversion Device>

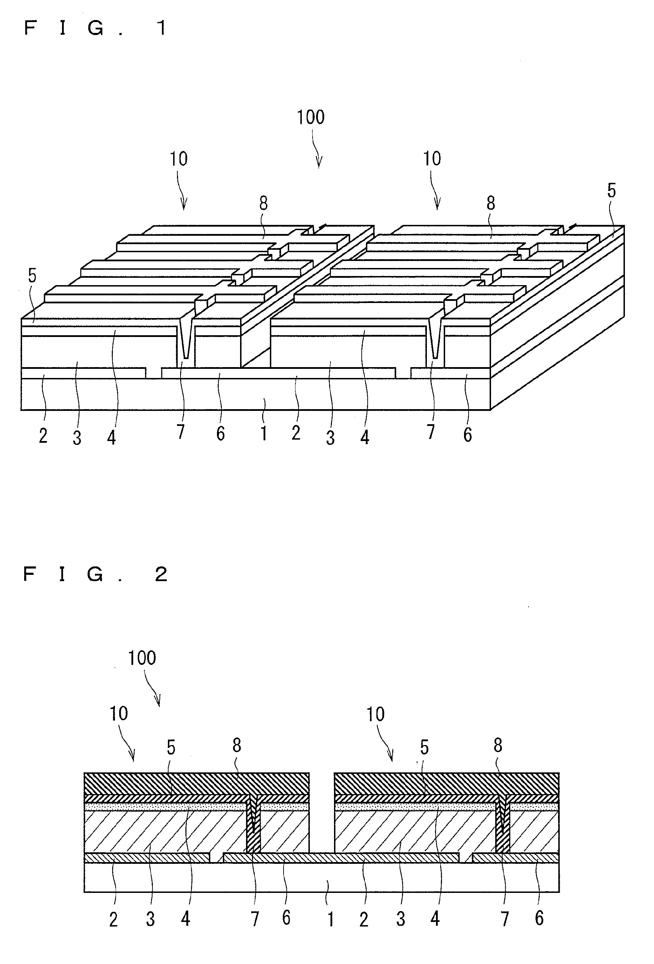

As shown in Fig. 1 and Fig. 2, a photoelectric conversion module 100 includes a plurality of photoelectric conversion devices 10. The photoelectric conversion devices 10 are arranged in a planar configuration on a substrate 1. The photoelectric conversion devices 10 are electrically connected in series with each other.

Each of the photoelectric conversion devices 10 includes a first electrode layer 2, a first semiconductor layer 3, a second semiconductor layer 4, a second electrode layer 5, a third electrode layer 6, a connection conductor 7, and collecting electrodes 8. Specifically, the first and third electrode layers 2 and 6 are provided on the substrate 1. The first semiconductor layer 3 is provided on the first and third electrode layers 2 and 6. The second semiconductor layer 4 is provided on the first semiconductor layer 3. The second electrode layer 5 is provided on the second semiconductor layer 4. The collecting electrodes 8 are provided on the second electrode layer 5. In an instance illustrated in this embodiment, the first semiconductor layer 3 serves as a light-absorbing layer, the second semiconductor layer 4 serves as a buffer layer, and the first semiconductor layer 3 and the second semiconductor layer 4 constitute a hetero junction region. It should be noted that the second semiconductor layer 4 may serve as a light-absorbing layer.

The first electrode layer 2 and the third electrode layer 6 are disposed in a planar configuration between the first semiconductor layer 3 and the substrate 1, and are spaced apart from each other. The connection conductor 7 is provided so as to divide a multi-layer laminate including the first semiconductor layer 3 and the second semiconductor layer 4 in a single photoelectric conversion device 10, and establishes an electrical connection between the second electrode layer 5 and the third electrode layer 6. The third electrode layer 6 is integral with the first electrode layer 2 of an adjacent one of the photoelectric conversion devices 10, and is a portion extending from this first electrode layer 2. In this configuration, adjacent ones of the photoelectric conversion devices 10 are electrically connected in series with each other. In the photoelectric conversion devices 10, a photoelectric conversion is performed by the first semiconductor layer 3 and the second semiconductor layer 4 lying between the first electrode layer 2 and the second electrode layer 5.

The substrate 1 is provided to support the photoelectric conversion devices 10. Examples of a material used for the substrate 1 include glass, ceramic, resin, metal and the like.

The first electrode layer 2 and the third electrode layer 6 are electrode layers provided on the substrate 1 and mainly including a good conductor. Examples of a material used for the first electrode layer 2 and the third electrode layer 6 include conductors such as molybdenum, aluminum, titanium, gold and the like. The first electrode layer 2 and the third electrode layer 6 can be formed on the substrate 1 by a sputtering method, a vapor-deposition method or the like.

The first semiconductor layer 3 includes a semiconductor which performs such a photoelectric conversion as to absorb light to create an electrical charge. Examples of a semiconductor capable of photoelectric conversion and applicable herein include a group I-III-VI compound semiconductor and a group II-VI compound semiconductor which are chalcopyrite-based compound semiconductors.

The group I-III-VI compound semiconductor refers to a semiconductor mainly including a group I-III-VI compound. The semiconductor mainly including a group I-III-VI compound refers to a semiconductor including not less than 70 mol % of the group I-III-VI compound (the term "mainly include" used hereinafter also means "include not less than 70 mol %"). The group I-III-VI compound is a compound mainly including a group IB element (also referred to as a group 11 element), a group IIIB element (also referred to as a group 13 element), and a group VIB element (also referred to as a group 16 element). Examples of the group I-III-VI compound used herein include Cu(In,Ga)Se₂ (also referred to as CIGS), Cu(In,Ga)(Se,S)₂ (also referred to as CIGSS), and CuInSe₂ (also referred to as CIS). It should be noted that Cu(In,Ga)Se₂ is a compound mainly including Cu, In, Ga and Se. Also, Cu(In,Ga)(Se,S)₂ is a compound mainly including Cu, In, Ga, Se and S. So long as the first semiconductor layer 3 mainly includes a group I-III-VI compound semiconductor, the efficiency of the photoelectric conversion performed by the first semiconductor layer 3 is increased even when the thickness of the first semiconductor layer 3 is not more than 10 µm.

The group II-VI compound semiconductor refers to a semiconductor mainly including a II-VI compound. The II-VI compound is a compound mainly including a group IIB element (also referred to as a group 12 element), and a group VIB element. Examples of the group II-VI compound semiconductor used herein include ZnS, ZnSe, ZnTe, CdS, CdSe, CdTe and the like.

The first semiconductor layer 3 is formed by performing the following steps (i) and (ii) in succession.

(i) A solution (also referred to as a semiconductor layer forming solution) including a metallic element (herein, either a group IB element and a group IIIB element or a group IIB element, for example) mainly contained in a desired semiconductor is applied onto the first electrode layer 2 and the third electrode layer 6, and is then dried. This forms a film as a precursor (also referred to as a precursor layer). The semiconductor layer forming solution used in this embodiment is a semiconductor layer forming solution in which fine particles containing a metallic element are dispersed, whereby the good first semiconductor layer 3 having a desired thickness can be easily formed. The precursor layer may be a laminate of multiple layers different in composition from each other (also referred to as a multi-layer laminate).

(ii) A heat treatment is performed on the precursor layer to form the first semiconductor layer 3.

The second semiconductor layer 4 is a layer provided on the first semiconductor layer 3 and mainly including a semiconductor. The second semiconductor layer 4 may have a thickness, for example, in the range of 10 to 200 nm. A configuration can be contemplated in which the second semiconductor layer 4 is not formed but the second electrode layer 5 is formed on the first semiconductor layer 3.

The semiconductor mainly included in the second semiconductor layer 4 and the semiconductor mainly included in the first semiconductor layer 3 are, for example, different in conductivity type from each other. For example, a configuration may be employed in which the first semiconductor layer 3 mainly includes a p-type semiconductor and the second semiconductor layer 4 mainly includes an n-type semiconductor. Also, another configuration may be employed in which the first semiconductor layer 3 mainly includes an n-type semiconductor and the second semiconductor layer 4 mainly includes a p-type semiconductor.

A leakage current is reduced when the electrical resistivity of the second semiconductor layer 4 is not less than 1 Ω·cm. Examples of the material of the semiconductor mainly included in the second semiconductor layer 4 and used herein include CdS, ZnS, ZnO, In₂Se₃, In(OH,S), (Zn,In)(Se,OH), (Zn,Mg)O and the like. In(OH,S) is a compound mainly including In, OH and S. (Zn,In)(Se,OH) is a compound mainly including Zn, In, Se and OH. (Zn,Mg)O is a compound mainly including Zn, Mg and O. When the second semiconductor layer 4 has light permeability to a wavelength range of light which the first semiconductor layer 3 is able to absorb, the proportion of light reaching the first semiconductor layer 3 to light impinging upon the photoelectric conversion module 100 is increased.

The second electrode layer 5 is a transparent film (also referred to as a transparent conductive film) which has electrical conductivity and mainly includes a material such as ITO and ZnO. The second electrode layer 5 may include a semiconductor of a conductivity type different from that of the first semiconductor layer 3. When the thickness of the second electrode layer 5, for example, is in the range of 0.05 to 3.0 µm, some transparency to light and some electrical conductivity of the second electrode layer 5 are ensured. The second electrode layer 5 is formed by a sputtering method, a vapor deposition method, a chemical vapor deposition (CVD) method, or the like. The second electrode layer 5 is a layer lower in electrical resistivity than the second semiconductor layer 4, and draws an electrical charge produced in the first semiconductor layer 3. When the second electrode layer 5 has a resistivity of less than 1 Ω·cm and a sheet resistance of not more than 50 Ω·/□ (ohms per square), the electrical charge is well drawn by the second electrode layer 5.

When the second electrode layer 5 has light permeability to a wavelength range of light which the first semiconductor layer 3 is able to absorb, the proportion of light reaching the first semiconductor layer 3 to light impinging upon the photoelectric conversion module 100 is increased. When the thickness of the second electrode layer 5 is in the range of 0.05 to 0.5 µm, the light permeability of the second electrode layer 5 is increased, so that the current produced by the photoelectric conversion is well transmitted by the second electrode layer 5. When the second electrode layer 5 and the second semiconductor layer 4 have an equal refractive index, light reflection losses at an interface between the second electrode layer 5 and the second semiconductor layer 4 are reduced.

In the photoelectric conversion module 100, the photoelectric conversion devices 10 each having the aforementioned configuration are arranged and electrically connected to each other.

The connection conductor 7 mainly includes a material having electrical conductivity. This connection conductor 7 may be formed in the step of forming the second electrode layer 5. In other words, the connection conductor 7 may be integral with the second electrode layer 5. This simplifies the steps of forming the second electrode layer 5 and the connection conductor 7 to increase the reliability of the electrical connection between the connection conductor 7 and the second electrode layer 5.

In such a configuration, the first semiconductor layer 3 of each of the photoelectric conversion devices 10 performs the photoelectric conversion well. The connection conductor 7 electrically connects the photoelectric conversion devices 10 in series, whereby the current generated by the first semiconductor layer 3 is drawn.

The collecting electrodes 8 mainly include a material excellent in conductivity, and supplement the electrical conduction in the second electrode layer 5. The presence of the collecting electrodes 8 allows the reduction in the thickness of the second electrode layer 5, thereby increasing the light permeability of the second electrode layer 5. Specifically, when the collecting electrodes 8 are provided on the second electrode layer 5, the second electrode layer 5 and the collecting electrodes 8 are able to efficiently draw the current generated by the first semiconductor layer 3, while the light permeability of the second electrode layer 5 is increased. As a result, electric power generation efficiency of the photoelectric conversion devices 10 is increased.

The collecting electrodes 8 extend in linear form from one edge of each of the photoelectric conversion devices 10 to the connection conductor 7, for example, as shown in Fig. 1. Thus, the electrical charge produced by the photoelectric conversion in the first semiconductor layer 3 is collected through the second electrode layer 5 into the collecting electrodes 8. This electrical charge is well transmitted through the connection conductor 7 to an adjacent one of the photoelectric conversion devices 10.

When the width of the collecting electrodes 8 is in the range of 50 to 400 µm, light directed toward the first semiconductor layer 3 is less prone to be intercepted, so that good electrical conductivity of the collecting electrodes 8 is achieved. Also, the collecting electrodes 8 may have a plurality of branches.

The collecting electrodes 8 are formed, for example, by a method such that a metal paste including a metal powder such as silver dispersed in a resin binder and the like is printed in a predetermined pattern and is then hardened.

### <(2) Method for Forming First Semiconductor Layer>

In this embodiment, the first semiconductor layer 3 is formed by using a semiconductor layer forming solution in which fine particles are dispersed.

### <(2-1) Semiconductor Layer Forming Solution >

The semiconductor layer forming solution includes, for example, a metallic element, an organic compound containing a chalcogen element, a Lewis base organic compound, and fine particles containing the metallic element.

The metallic element included in the semiconductor layer forming solution includes a metallic element (also referred to as a starting metallic element) serving as a starting material of the first semiconductor layer 3. For example, when the first semiconductor layer 3 mainly includes a group I-III-VI compound semiconductor, the metallic element mainly includes, for example, a group IB element and a group IIIB element. In this case, a semiconductor of a chalcopyrite type is well formed. When the first semiconductor layer 3 mainly includes a group II-VI compound semiconductor, the metallic element mainly includes, for example, a group IIB element.

The organic compound containing a chalcogen element is an organic compound mainly containing a chalcogen element. The chalcogen element includes S, Se and Te among the group VIB elements.

When the chalcogen element is S, examples of the organic compound containing a chalcogen element used herein include thiol, sulfide, disulfide, thiophene, sulfoxide, sulfone, thioketone, sulfonic acid, sulfonic acid ester and sulfonic acid amide. When a thiol, a sulfide, a disulfide or the like is employed as the organic compound containing a chalcogen element, a complex of the starting metallic element is formed, so that a semiconductor layer forming solution containing a high concentration of the starting metallic element is produced. Also, when the organic compound containing a chalcogen element used herein includes a phenyl group, the coating property of the semiconductor layer forming solution is increased. Examples of the organic compound containing a chalcogen element including a phenyl group used herein include thiophenol, diphenyl sulfide, and derivatives thereof.

When the chalcogen element is Se, examples of the organic compound containing a chalcogen element used herein include selenol, selenide, diselenide, selenoxide, and selenone. When a selenol, a selenide, a diselenide or the like is employed as the organic compound containing a chalcogen element, a complex of the starting metallic element is formed, so that a semiconductor layer forming solution containing a high concentration of the starting metallic element is produced. Also, when the organic compound containing a chalcogen element used herein includes a phenyl group, the coating property of the semiconductor layer forming solution is increased. Examples of the organic compound containing a chalcogen element including a phenyl group used herein include phenyl selenol, phenyl selenide, diphenyl diselenide, and derivatives thereof.

When the chalcogen element is Te, examples of the organic compound containing a chalcogen element used herein include tellurol, telluride, and ditelluride.

The Lewis base organic compound refers to an organic compound including a functional group that can become a Lewis base. Examples of the functional group that can become a Lewis base include a functional group comprising a group VB element (also referred to as a group 15 element) including an unshared electron pair, and a functional group comprising a group VIB element including an unshared electron pair. Specific examples of such a functional group include amino group (any one of primary, secondary and tertiary amines), carbonyl group, and cyano group. Specific examples of the Lewis base organic compound include pyridines, anilines, triphenyl phosphines, 2,4-pentanedione, 3-methyl-2,4-pentanedione, triethylamine, triethanolamine, acetonitrile, benzil, benzoin, and derivatives thereof. When the Lewis base organic compound is a nitrogen-containing organic compound, the property of being able to dissolve the starting metallic element (also referred to as solubility) is increased. Also, when the boiling point of the Lewis base organic compound is not less than 100°C, the coating property of the semiconductor layer forming solution is increased.

For the production of the semiconductor layer forming solution, the starting metallic element of the first semiconductor layer 3 is initially dissolved in a solution including the organic compound containing a chalcogen element and the Lewis base organic compound, whereby a solution (also referred to as a starting solution) including the starting metallic element of the first semiconductor layer 3 is prepared. This produces the starting solution containing the starting metallic element, the organic compound containing a chalcogen element, and the Lewis base organic compound.

Next, the starting solution is heated to produce fine particles including the starting metallic element. Using the fine particles, the semiconductor layer forming solution in which the fine particles are dispersed can be produced. Each of the fine particles mainly includes a metal chalcogenide that is a compound of the starting metallic element (for example, either a group IB element and a group IIIB element or a group IIB element) and a chalcogen element included in the organic compound containing a chalcogen element. Also, a chalcogen element in addition to the organic compound containing a chalcogen element may be dissolved in the starting solution. In this case, the dissolved chalcogen element is also able to react with the starting metallic element to become a fine particle. The organic compound containing a chalcogen element not only becomes a chalcogen element source for forming a fine particle but also has the function of bonding to the surface of a fine particle to stabilize the fine particle, thereby reducing the aggregation of the fine particles.

When the fine particles are dispersed in the semiconductor layer forming solution, the viscosity of the semiconductor layer forming solution is increased. Further, during the heat treatment of the precursor layer formed by the application of the semiconductor layer forming solution, the fine particles can act as nuclei to promote the crystal growth of a semiconductor. As a result, the crystallinity of the first semiconductor layer 3 can be increased.

When the fine particles are dispersed and the starting solution is present in the semiconductor layer forming solution, the starting metallic element can be present between the fine particles in the precursor layer formed by the application of the semiconductor layer forming solution. This allows the crystallization of a semiconductor between the fine particles to proceed well during the heat treatment of the precursor layer. As a result, the semiconductor included in the first semiconductor layer 3 becomes dense. Then, the conversion efficiency in the photoelectric conversion devices 10 can be easily increased.

The conversion efficiency refers to the proportion of the conversion from energy from sunlight to electrical energy in the photoelectric conversion device 10. For example, the conversion efficiency is derived by dividing the value of the electrical energy outputted from the photoelectric conversion device 10 by the value of the energy from sunlight impinging on the photoelectric conversion device 10 and then multiplying the result by 100.

When the fine particles have an average particle diameter of not more than 1 µm, the dispersibility of the fine particles is increased and the aggregation of the fine particles is reduced in the semiconductor layer forming solution. Also, when the fine particles and the first semiconductor layer 3 have the same composition, impurities having other than a desired composition are less prone to be mixed in the first semiconductor layer 3. In other words, the purity of the semiconductor included in the first semiconductor layer 3 is increased.

### <(2-2) Production of Starting Solution>

A solvent (also referred to as a mixed solvent Mx) including an organic compound containing a chalcogen element and a Lewis base organic compound is able to dissolve a metallic element well. More specifically, the use of the mixed solvent Mx allows the metallic element to be dissolved in greater amounts than the metallic element dissolved by the use of the organic compound containing a chalcogen element alone or the Lewis base organic compound alone. Because of the use of the mixed solvent Mx herein, the starting metallic element is dissolved in greater amounts by a high bonding strength between the starting metallic element and the mixed solvent Mx. Thus, the content of the starting metallic element in the semiconductor layer forming solution can be increased. For example, the semiconductor layer forming solution having a starting metallic element content of not less than 2% by mass can be produced.

When the content of the starting metallic element in the semiconductor layer forming solution is high in this manner, the viscosity of the semiconductor layer forming solution is increased. This allows the production of the semiconductor layer forming solution including a high concentration of the starting metallic element and having a viscosity suitable for the application. Further, when the fine particles including the starting metallic element are dispersed in the semiconductor layer forming solution, the viscosity of the semiconductor layer forming solution is further increased. For example, the viscosity of the semiconductor layer forming solution can be in the range of 20 to 100 mPa·s. At this time, the single application using the semiconductor layer forming solution allows the formation of a relatively thick good precursor. During the heat treatment of the precursor layer, the fine particles can act as nuclei to promote the crystal growth of the semiconductor. As a result, the crystallinity of the first semiconductor layer 3 can be increased. Thus, the first semiconductor layer 3 having a desired thickness and crystallized uniformly well can be easily formed.

The mixed solvent Mx is excellent in handleability, when prepared so as to be liquefied at room temperature. In the mixed solvent Mx, the weight of the organic compound containing a chalcogen element can be set, for example, in the range of one to ten times the weight of the Lewis base organic compound. Thus, a chemical bond between the metallic element and the organic compound containing a chalcogen element and a chemical bond between the organic compound containing a chalcogen element and the Lewis base organic compound are formed well, so that the starting solution and the semiconductor layer forming solution which have a high total concentration of the metallic element are produced.

A specific example of a method for producing the starting solution used herein is a method such that the starting metallic element in at least one state selected from among the state of a single element, the state of an alloy and the state of a metallic salt is dissolved in the mixed solvent Mx. When the starting metallic element in at least one state selected from among the state of a single element and the state of an alloy of two or more metallic elements included in the starting metallic element is directly dissolved in the mixed solvent Mx, impurities are less prone to be mixed in the first semiconductor layer 3. In other words, the purity of the semiconductor included in the first semiconductor layer 3 can be increased.

For example, when the first semiconductor layer 3 mainly includes a group I-III-VI compound semiconductor, a group IB metal in at least one state selected from among the state of a single element and the state of an alloy is directly dissolved in the mixed solvent Mx, whereby the starting solution is produced. Alternatively, a group IIIB metal in at least one state selected from among the state of a single element and the state of an alloy may be directly dissolved in the mixed solvent Mx, whereby the starting solution is produced. Further, a group IB metal and a group IIIB metal in at least one state selected from among the state of a single element and the state of an alloy may be directly dissolved in the mixed solvent Mx, whereby the starting solution is produced. The alloy termed herein should just be even an alloy of metallic elements mainly included in the first semiconductor layer 3. Also, when a chalcogen element in addition to the organic compound containing a chalcogen element is dissolved in the starting solution, the chalcogen element in the state of a single element may be directly dissolved in the mixed solvent Mx.

### <(2-3) Production of Semiconductor Layer Forming Solution >

The starting metallic element, the organic compound containing a chalcogen element and the Lewis base organic compound form a complex in the starting solution, and the starting metallic element and the chalcogen element close to each other exist with stability. Thus, the fine particles mainly including a compound of the starting metallic element and the chalcogen element can be produced well by heating the starting solution.

A plurality of methods different in various conditions such as the heating conditions of the starting solution can be contemplated as a method for producing the semiconductor layer forming solution in which the fine particles are dispersed. First to third methods of producing the semiconductor layer forming solution will be described one by one.

### <(2-3-1) First Method for Producing Semiconductor Layer Forming Solution >

Heating the starting solution at a predetermined temperature produces the fine particles to produce the semiconductor layer forming solution including the starting solution and including the fine particles dispersed therein. The predetermined temperature used herein is in the range of 140 to 210°C, for example.

For example, when the first semiconductor layer 3 mainly includes CIGS, the starting metallic element used herein is Cu, In and Ga, the organic compound containing a chalcogen element used herein is phenyl selenol, and the Lewis base organic compound used herein is an aniline. By heating under the conditions that the heating temperature is in the range of 140 to 210°C and heating time is in the range of one minute to 20 hours, the fine particles including CIGS and having an average particle diameter in the range of 30 to 320 nm are produced in the starting solution.

Also, by setting the heating temperature in the range of 140 to 195°C, the fine particles including CIGS and having an average particle diameter in the range of 30 to 300 nm may be produced in the starting solution. In this case, the aggregation and precipitation of the fine particles are less prone to occur in the semiconductor layer forming solution, and the coating property of the semiconductor layer forming solution is increased.

Also, by setting the heating temperature in the range of 155 to 210°C, the fine particles including CIGS and having an average particle diameter in the range of 50 to 320 nm may be produced in the starting solution. In this case, the fine particles act as nuclei to promote the crystal growth of the semiconductor. As a result, the crystallinity of the first semiconductor layer 3 is increased. This increases the efficiency of the photoelectric conversion in the first semiconductor layer 3.

Further, by setting the heating temperature in the range of 155 to 195°C, the fine particles including CIGS and having an average particle diameter in the range of 50 to 300 nm may be produced in the starting solution. In this case, high conversion efficiency and the coating property of the semiconductor layer forming solution are compatible with each other.

The semiconductor layer forming solution may be produced, for example, by performing the following steps (1A) to (1D) in succession.

(1A) The starting solution is divided into two: a first starting solution, and a second starting solution.

(1B) Heating the first starting solution at a predetermined temperature produces fine particles. The predetermined temperature used herein is in the range of 140 to 210°C, for example.

(1C) Using a centrifugal separator and the like, the fine particles are extracted from the solution including the fine particles produced in the step (1B).

(1D) The fine particles extracted in the step (1C) are added to the second starting solution, so that the semiconductor layer forming solution is produced. That is, the fine particles are dispersed in the second starting solution.

In this manner, the extraction of the fine particles from the first starting solution allows the separation of unnecessary components such as by-products generated during the production of the fine particles. This reduces the ratio of the unnecessary components in the semiconductor layer forming solution. As a result, the semiconductor mainly included in the first semiconductor layer 3 becomes better.

### <(2-3-2) Second Method for Producing semiconductor layer forming solution >

The semiconductor layer forming solution including the fine particles having a wide particle diameter distribution may be produced by mixing two or more solutions including the fine particles different in average particle diameter from each other. The fine particles different in average particle diameter from each other are formed by dividing the starting solution into starting solutions and heating the starting solutions under different conditions. The semiconductor layer forming solution is produced, for example, by performing the following steps (2A) to (2C) in succession.

(2A) The starting solution is divided into a first starting solution and a second starting solution.

(2B) Heating the first starting solution at a first temperature for a predetermined length of time produces fine particles (also referred to as first fine particles) containing the starting metallic element. This produces a solution (also referred to as a first intermediate solution) including the starting solution and including the first fine particles dispersed therein. Each of the first fine particles contains, for example, a metal chalcogenide. Heating the second starting solution at a second temperature higher than the first temperature for a predetermined length of time produces fine particles (also referred to as second fine particles) containing the starting metallic element. This produces a solution (also referred to as a second intermediate solution) including the starting solution and including the second fine particles dispersed therein. Each of the second fine particles contains, for example, a metal chalcogenide. The average particle diameter (also referred to as a second average particle diameter) of the second fine particles is greater than the average particle diameter (also referred to as a first average particle diameter) of the first fine particles because the second temperature is higher than the first temperature in this case.

(2C) The first intermediate solution and the second intermediate solution which are produced in the step (2B) are mixed together, so that the semiconductor layer forming solution is produced. Fine particles including the first fine particles and the second fine particles are dispersed in this semiconductor layer forming solution. The particle diameters of the fine particles can be relatively small and can be distributed in a wide range by adjusting the first temperature and the second temperature.

When the precursor layer is formed by the application of the semiconductor layer forming solution produced in this manner, fine particles having a relatively small particle diameter go into gaps between fine particles having a relatively large particle diameter. Thus, the precursor layer is in such a dense state as to be filled with the fine particles at a high density. Then, the production of the gaps is reduced during the heat treatment of the precursor layer. As a result, the first semiconductor layer 3 mainly including, for example, dense polycrystals is formed. This increases the efficiency of the photoelectric conversion in the first semiconductor layer 3.

The precursor layer is in a dense state, for example, when the second average particle diameter is in the range of 1.5 to 11 times the first average particle diameter. As a result, the first semiconductor layer 3 mainly including dense polycrystals is formed. At this time, it can be contemplated that, for example, the first average particle diameter is in the range of 30 to 200 nm and the second average particle diameter is in the range of 100 to 500 nm. When the second average particle diameter is in the range of 1.5 to 10 times the first average particle diameter, the coating property of the semiconductor layer forming solution is improved. At this time, it can be contemplated that, for example, the first average particle diameter is in the range of 30 to 200 nm and the second average particle diameter is in the range of 100 to 300 nm. Further, when the second average particle diameter is in the range of 3 to 10 times the first average particle diameter, the durability of the first semiconductor layer 3 is improved.

So long as the first heating temperature of the first starting solution is low, the value (an average particle diameter ratio) obtained by dividing the second average particle diameter by the first average particle diameter can be in the range of 3 to 10, for example, even if the second heating temperature of the second starting solution is decreased to approximately 190°C. For example, when the first average particle diameter is 10 nm, the second average particle diameter may be reduced to approximately 30 nm. Also, when the second average particle diameter is 30 nm, the second average particle diameter may be reduced to approximately 90 nm.

For example, when the first semiconductor layer 3 mainly includes CIGS, the starting metallic element used herein is Cu, In and Ga, the organic compound containing a chalcogen element used herein is phenyl selenol, and the Lewis base organic compound used herein is an aniline. Then, for example, the first starting solution is heated under the conditions that the first temperature is in the range of 140 to 160°C and heating time is in the range of one minute to 20 hours. This produces the first fine particles including CIGS and having a first average particle diameter in the range of 30 to 80 nm in the first starting solution. Also, the second starting solution is heated under the conditions that the second temperature is in the range of 190 to 200°C and heating time is in the range of one minute to 20 hours. This produces the second fine particles including CIGS and having a second average particle diameter of approximately 300 nm in the second starting solution.

The semiconductor layer forming solution may be produced by heating three or more starting solutions under different heating conditions and then mixing the three or more starting solutions together. For example, a third intermediate solution including third fine particles having a third average particle diameter and a fourth intermediate solution including fourth fine particles having a fourth average particle diameter may be mixed together in addition to the first intermediate solution including the first fine particles having the first average particle diameter and the second intermediate solution including the second fine particles having the second average particle diameter.

A configuration such that the first starting solution does not remain in the first intermediate solution can be contemplated. Also, a configuration such that the second starting solution does not remain in the second intermediate solution can be contemplated. At this time, the first intermediate solution, the second intermediate solution and the starting solution may be mixed together to produce the semiconductor layer forming solution.

The semiconductor layer forming solution may be produced by extracting the first fine particles from the first intermediate solution by using a centrifugal separator and the like and then mixing the extracted first fine particles with the second intermediate solution. Also, the semiconductor layer forming solution may be produced by extracting the second fine particles from the second intermediate solution by using a centrifugal separator and the like and then mixing the extracted second fine particles with the first intermediate solution. Further, the semiconductor layer forming solution may be produced by extracting the first fine particles from the first intermediate solution by using a centrifugal separator and the like, extracting the second fine particles from the second intermediate solution by using a centrifugal separator and the like and then dispersing the first fine particles and the second fine particles in a solution. As an example, the semiconductor layer forming solution can be produced by dispersing the first fine particles and the second fine particles in the starting solution.

When the starting solution is included in the semiconductor layer forming solution, the starting metallic element can be present between the fine particles in the precursor layer. This allows the crystallization of the semiconductor between the fine particles to proceed well during the heat treatment of the precursor layer. As a result, the semiconductor included in the first semiconductor layer 3 becomes dense. Thus, the conversion efficiency in the photoelectric conversion devices 10 can be easily increased.

### <(2-3-3) Third Method for Producing Semiconductor Layer Forming Solution >

The semiconductor layer forming solution including the fine particles having a wide particle diameter distribution dispersed herein may be produced by heating the starting solution in at least two steps. The semiconductor layer forming solution including the fine particles having a wide particle diameter distribution dispersed herein is produced, for example, by performing the following steps (3A) and (3B) in succession.

(3A) Heating the starting solution at a first temperature for a predetermined length of time produces fine particles (also referred to as first fine particles) containing the starting metallic element. This produces a solution (also referred to as an intermediate solution) including the starting solution and including the first fine particles dispersed therein. The standard deviation for the particle size distribution of the first fine particles is a first standard deviation, and the average particle diameter of the first fine particles is a first average particle diameter. The first fine particles contain, for example, a metal chalcogenide.

(3B) Heating the intermediate solution at a second temperature higher than the first temperature for a predetermined length of time produces fine particles (also referred to as second fine particles) containing the starting metallic element. This produces the semiconductor layer forming solution including the starting solution and including the second fine particles dispersed therein. The standard deviation for the particle size distribution of the second fine particles is a second standard deviation greater than the first standard deviation, and the average particle diameter of the second fine particles is a second average particle diameter greater than the first average particle diameter. The second fine particles contain, for example, a metal chalcogenide.

In the step (3A), the first fine particles are formed by heating the starting solution at the first temperature, and the first fine particles are stabilized while having some average particle diameter. Next, during the heating of the intermediate solution including the first fine particles at the second temperature higher than the first temperature in the step (3B), some of the first fine particles grow relatively larger, and the remainder of the fine particles slightly or hardly grow. Thus, the particle diameters of the second fine particles are distributed in a wide range.

In other words, the step of maintaining the starting solution at the first temperature for the predetermined length of time to stabilize the particle diameters of the first fine particles exists. Thus, the growth of some of the first fine particles can be reduced during the subsequent heating of the intermediate solution at the second temperature higher than the first temperature. As a result, the particle diameters of the second fine particles can be distributed in a wide range. The predetermined length of time is set, for example, in the range of one minute to 20 hours.

When the precursor layer is formed by the application of the semiconductor layer forming solution produced in this manner, fine particles having a relatively small particle diameter go into gaps between fine particles having a relatively large particle diameter. Thus, the precursor layer is in such a dense state as to be filled with the fine particles at a high density. Then, the production of voids is reduced during the heat treatment of the precursor layer. As a result, the first semiconductor layer 3 mainly including, for example, dense polycrystals is formed. This increases the efficiency of the photoelectric conversion in the first semiconductor layer 3.

The semiconductor layer forming solution including the fine particles having a wide particle diameter distribution may be produced by heating the starting solution in three or more steps. When a transition is made from the heating treatment at the first temperature to the heating treatment at the second temperature, the temperature of the intermediate solution may be increased immediately from the first temperature to the second temperature, or may be increased to the second temperature after the intermediate solution is once cooled down from the first temperature. A temperature change during the increase and decrease in temperature in the heat treatments at the first and second temperatures is set to a slow or gradual change of not more than ±5°C/h.

When, for example, the second standard deviation is in the range of 15 to 35 nm, the precursor layer is in a dense state. As a result, the first semiconductor layer 3 mainly including dense polycrystals is formed. At this time, it can be contemplated that, for example, the second average particle diameter of the second fine particles is in the range of 200 to 400 nm. Also, when the second standard deviation is in the range of 15 to 30 nm, the coating property of the semiconductor layer forming solution is improved. At this time, it can be contemplated that, for example, the second average particle diameter is in the range of 200 to 350 nm.

For example, when the first semiconductor layer 3 mainly includes CIGS, the starting metallic element used herein is Cu, In and Ga, the organic compound containing a chalcogen element used herein is phenyl selenol, and the Lewis base organic compound used herein is an aniline. Then, for example, the starting solution is heated under the conditions that the first temperature is in the range of 140 to 160°C and heating time is in the range of one minute to 20 hours. This produces the first fine particles including CIGS and having a first average particle diameter in the range of 30 to 80 nm and a first standard deviation of approximately 5 nm in the starting solution. The intermediate solution including the first fine particles is heated under the conditions that the second temperature is in the range of 190 to 200°C and heating time is in the range of one minute to 20 hours. This produces the second fine particles including CIGS and having a second average particle diameter of approximately 300 nm and a second standard deviation in the range of 15 to 30 nm in the starting solution.

A configuration such that the starting solution is not included in the intermediate solution can be contemplated. Also, a configuration can be contemplated such that the starting solution is not included in a solution including the second fine particles dispersed therein when the intermediate solution has been heated at the second temperature to produce the second fine particles. At this time, the second fine particles and the starting solution may be mixed together to produce the semiconductor layer forming solution.

The second fine particles may be produced by heating at the second temperature after the first fine particles are extracted from the intermediate solution by using a centrifugal separator and the like and then mixed with the starting solution. Also, the semiconductor layer forming solution may be produced by extracting the second fine particles from a solution including the second fine particles by using a centrifugal separator and the like and then mixing the extracted second fine particles with the starting solution.

When the starting solution is included in the semiconductor layer forming solution, the starting metallic element can be present between the fine particles in the precursor layer. This allows the crystallization of the semiconductor between the fine particles to proceed well during the heat treatment of the precursor layer. As a result, the semiconductor included in the first semiconductor layer 3 becomes dense. Thus, the conversion efficiency in the photoelectric conversion device 10 can be easily increased.

### <(2-4) Application of Semiconductor Layer Forming Solution >

The semiconductor layer forming solution is applied onto the first and third electrode layers 2 and 6 formed on the substrate 1 and into the gap between the first electrode layer 2 and the third electrode layer 6. Examples of the method for such application include a spin coater, screen printing, dipping, spraying, and a die coater. The applied semiconductor layer forming solution is dried to produce the precursor layer. This drying is performed, for example, in an inert atmosphere or in a reductive atmosphere. The temperature during the drying is set, for example, in the range of 50 to 300°C.

### <(2-5) Heat Treatment of Precursor Layer>

A heat treatment is performed on the precursor layer to form the first semiconductor layer 3. The thickness of the first semiconductor layer 3 is set, for example, in the range of 1.0 to 2.5 µm. Since the heat treatment is performed in an inert atmosphere or in a reductive atmosphere, the oxidation of the precursor layer is decreased, so that the first semiconductor layer 3 includes a good semiconductor. The inert atmosphere or the reductive atmosphere may be, for example, any one selected from among a nitrogen atmosphere, a hydrogen atmosphere, and an atmosphere of a gas mixture of hydrogen and nitrogen or argon. A heat treatment temperature may be, for example, in the range of 400 to 600°C.

During this heat treatment, the fine particles of the metal chalcogenide react with each other to form polycrystals. Also, when the organic compound containing a chalcogen element and the starting metallic element in addition to the fine particles are included in the semiconductor layer forming solution for the formation of the precursor layer, a chalcogen element included in the organic compound containing a chalcogen element reacts with another starting metallic element, so that the first semiconductor layer 3 including the chalcogen element is formed. Also, when the starting metallic element including a chalcogen element is dissolved in the semiconductor layer forming solution, the chalcogen element dissolved in the semiconductor layer forming solution reacts with another starting metallic element, so that the first semiconductor layer 3 including the chalcogen element is formed. Further, when a gas containing a chalcogen element is supplied during the heat treatment of the precursor layer, the chalcogen element included in the gas reacts with another starting metallic element, so that the first semiconductor layer 3 including the chalcogen element is formed. This achieves sufficient supply of the chalcogen element which is prone to shortages due to vaporization and the like. As a result, the first semiconductor layer 3 mainly including a semiconductor having a desired composition can be formed.

For example, when the first semiconductor layer 3 mainly includes a group I-III-VI compound semiconductor, the precursor layer may be formed by using a starting solution prepared by dissolving a group IB element such as Cu, a group IIIB element such as Ga and In, and a group VIB element such as Se in the mixed solvent Mx. At this time, the heat treatment is performed on the precursor layer to form the first semiconductor layer 3 mainly including the group I-III-VI compound semiconductor. Also, the precursor layer may be formed by using a starting solution prepared by dissolving a group IB element such as Cu, and a group IIIB element such as Ga and In in the mixed solvent Mx. At this time, the heat treatment is performed on the precursor layer in a atmosphere of a gas including a group VIB element such as Se to form the first semiconductor layer 3 mainly including the group I-III-VI compound semiconductor.

### <(3) Specific Examples of Semiconductor Layer and Photoelectric Conversion Device>

Specific examples of the first semiconductor layer 3 and the photoelectric conversion device 10 which are producible by a manufacturing method according to the aforementioned embodiment will be described.

### <(3-1) Production of Semiconductor Layer Forming Solution >

First, Benzeneselenol was dissolved in aniline to be 100 mol%, to thereby adjust a mixed solvent Mx. Then, Cu, In, Ga and Se in raw metal form were directly dissolved in the mixed solvent Mx, so that a starting solution was produced. At this time, adjustments were made so that Cu was in an amount of 2.3% by mass, In was in an amount of 3.2% by mass, Ga was in an amount of 1.3% by mass, and Se was in an amount of 7.2% by mass of the mixed solvent Mx. In other words, the adjustments were made so that the total concentration of Cu, In, Ga and Se was 14.0% by mass in the starting solution.

Next, heat treatments and the like under various different conditions were performed on the starting solution to produce semiconductor layer forming solutions in Examples 1 to 21 in which fine particles were dispersed.

### <(3-1-1) Semiconductor Layer Forming Solutions in Examples 1 to 10>

The semiconductor layer forming solutions in Examples 1 to 10 were produced by heating the starting solution at eight different heating temperatures for 20 hours while stirring the starting solution. The eight different temperatures were as follows: 140, 155, 160, 175, 185, 190, 195 and 210°C. Specifically, the heating temperature in Example 1 was 140°C, the heating temperature in Example 2 was 155°C, the heating temperature in Example 3 was 160°C, and the heating temperature in Example 4 was 175°C. The heating temperature in Examples 5 and 6 was 185°C, the heating temperature in Examples 7 and 8 was 190°C, the heating temperature in Example 9 was 195°C, and the heating temperature in Example 10 was 210°C.

The average particle diameter of the fine particles included in the semiconductor layer forming solutions in Examples 1 to 10, and the standard deviation for the particle size distribution thereof took values as listed in Table 1.

**[Table 1]**

| | Heating Temperature (°C) | Average Particle Diameter (nm) | Standard Deviation (nm) | Remarks |
|---|---|---|---|---|
| Example 1 | 140 | 30 | 5 | - |
| Example 2 | 155 | 50 | 5 | - |
| Example 3 | 160 | 80 | 6 | - |
| Example 4 | 175 | 95 | 4 | - |
| Example 5 | 185 | 50 | 5 | - |
| Example 6 | 185 | 150 | 7 | - |
| Example 7 | 190 | 145 | 8 | - |
| Example 8 | 190 | 200 | 7 | - |
| Example 9 | 195 | 300 | 6 | - |
| Example 10 | 210 | 320 | 6 | Precipitates exist during heating. |

Specifically, in Example 1, the average particle diameter was 30 nm, and the standard deviation was 5 nm. In Example 2, the average particle diameter was 50 nm, and the standard deviation was 5 nm. In Example 3, the average particle diameter was 80 nm, and the standard deviation was 6 nm. In Example 4, the average particle diameter was 95 nm, and the standard deviation was 4 nm. In Example 5, the average particle diameter was 50 nm, and the standard deviation was 5 nm. In Example 6, the average particle diameter was 150 nm, and the standard deviation was 7 nm. In Example 7, the average particle diameter was 145 nm, and the standard deviation was 8 nm. In Example 8, the average particle diameter was 200 nm, and the standard deviation was 7 nm. In Example 9, the average particle diameter was 300 nm, and the standard deviation was 6 nm. In Example 10, the average particle diameter was 320 nm, and the standard deviation was 6 nm. In Example 10, precipitates including the fine particles were formed during the heating of the starting solution.

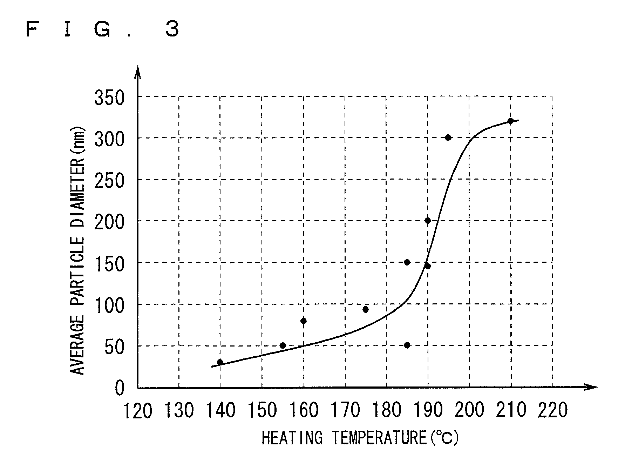

A relationship between the heating temperature and the average particle diameter of the fine particles in Examples 1 to 10 showed a relationship indicated by plotted solid circles in the graph of Fig. 3. The relationship showed a trend indicated by a curved line.

### <(3-1-2) Semiconductor Layer Forming Solutions in Examples 11 to 17>

The starting solution was divided into halves: a first starting solution and a second starting solution. First intermediate solutions in Examples 11 to 17 were produced by heating the first starting solution at six different heating temperatures (also referred to as first heating temperatures) for 20 hours while stirring the first starting solution. The six different first heating temperatures were as follows: 120, 140, 155, 160, 180 and 190°C. Specifically, the first heating temperature in Example 11 was 120°C, the first heating temperature in Examples 12 and 17 was 140°C, the first heating temperature in Example 13 was 155°C, and the first heating temperature in Example 14 was 160°C. The first heating temperature in Example 15 was 180°C, and the first heating temperature in Example 16 was 190°C.

On the other hand, second intermediate solutions in Examples 11 to 17 were produced by heating the second starting solution at two different heating temperatures (also referred to as second heating temperatures) for 20 hours while stirring the second starting solution. The two different second heating temperatures were as follows: 195° and 210°C. Specifically, the second heating temperature in Examples 11 to 16 was 195°C, and the second heating temperature in Example 17 was 210°C.

The average particle diameter (a first average particle diameter) of fine particles (first fine particles) included in the first intermediate solutions in Examples 11 to 17, and the average particle diameter (a second average particle diameter) of fine particles (second fine particles) included in the second intermediate solutions in Examples 11 to 17 took values as listed in Table 2.

**[Table 2]**

| | First Heating Temperature (°C) | First Average Particle Diameter (nm) | Second Heating Temperature (°C) | Second Average Particle Diameter (nm) | Average Particle Diameter Ratio | Remarks |
|---|---|---|---|---|---|---|
| Example 11 | 120 | - | 195 | 300 | - | - |
| Example 12 | 140 | 30 | 195 | 300 | 10 | - |
| Example 13 | 155 | 50 | 195 | 300 | 6 | - |
| Example 14 | 160 | 80 | 195 | 300 | 3.8 | - |
| Example 15 | 180 | 100 | 195 | 300 | 3 | - |
| Example 16 | 190 | 200 | 195 | 300 | 1.5 | Precipitates |
| Example 17 | 140 | 30 | 210 | 320 | 11 | Precipitates exist at second heating temperature. |

Specifically, in Examples 12 and 17, the first average particle diameter was 30 nm. In Example 13, the first average particle diameter was 50 nm. In Example 14, the first average particle diameter was 80 nm. In Example 15, the first average particle diameter was 100 nm. In Example 16, the first average particle diameter was 200 nm. The presence of the first fine particles was not confirmed in the first intermediate solution in Example 11.

In Examples 11 to 16, the second average particle diameter was 300 nm. In Example 17, the second average particle diameter was 320 nm. In Example 17, precipitates including the second fine particles were formed during the heating of the second starting solution.

The semiconductor layer forming solutions in Examples 11 to 17 were produced by mixing the first and second intermediate solutions. In each of Examples 11 to 17, the value (also referred to as an average particle diameter ratio) obtained by dividing the second average particle diameter by the first average particle diameter was that listed in Table 2. Specifically, the average particle diameter ratio in Example 12 was 10, the average particle diameter ratio in Example 13 was 6, the average particle diameter ratio in Example 14 was 3.8, the average particle diameter ratio in Example 15 was 3, the average particle diameter ratio in Example 16 was 1.5, and the average particle diameter ratio in Example 17 was 11.

### <(3-1-3) Semiconductor Layer Forming Solutions in Examples 18 to 21>

Intermediate solutions in Examples 18 to 21 were produced by heating the starting solution at a first heating temperature of 155°C for 20 hours while stirring the starting solution. Next, the semiconductor layer forming solutions in Examples 18 to 21 were produced by heating the intermediate solutions at four different heating temperatures (second heating temperatures) for 20 hours while stirring the intermediate solutions. The four different heating temperatures were as follows: 180, 195, 200 and 210°C. Specifically, the second heating temperature in Example 18 was 180°C, the second heating temperature in Example 19 was 195°C, the second heating temperature in Example 20 was 200°C, and the second heating temperature in Example 21 was 210°C.

The average particle diameter (a first average particle diameter) of fine particles (first fine particles) included in the intermediate solutions in Examples 18 to 21, and the standard deviation (a first standard deviation) for the particle size distribution thereof took values as listed in Table 3.

**[Table 3]**

| | First Heating Temperature (°C) | First Average Particle Diameter (nm) | First Standard Deviation (nm) | Second Heating Temperature (°C) | Second Average Particle Diameter (nm) | Second Standard Deviation (nm) | Remarks |
|---|---|---|---|---|---|---|---|
| Example 18 | 155 | 50 | 5 | 180 | 250 | 15 | - |
| Example 19 | 155 | 50 | 5 | 195 | 300 | 20 | - |
| Example 20 | 155 | 50 | 5 | 200 | 320 | 30 | - |
| Example 21 | 155 | 50 | 5 | 210 | 350 | 35 | Precipitates exist at second heating temperature. |

Specifically, in Examples 18 to 21, the first average particle diameter was 50 nm, and the first standard deviation was 5 nm.

The average particle diameter (a second average particle diameter) of fine particles (second fine particles) included in the semiconductor layer forming solutions in Examples 18 to 21, and the standard deviation (a second standard deviation) for the particle size distribution thereof took values as listed in Table 3.

Specifically, in Example 18, the second average particle diameter was 250 nm, and the second standard deviation was 15 nm. In Example 19, the second average particle diameter was 300 nm, and the second standard deviation was 20 nm. In Example 20, the second average particle diameter was 320 nm, and the second standard deviation was 30 nm. In Example 21, the second average particle diameter was 350 nm, and the second standard deviation was 35 nm. In Example 21, precipitates including the second fine particles were formed during the heating of the intermediate solution.

### <(3-1-4) Semiconductor Layer Forming Solution in Comparative Example>

Copper selenide, indium selenide and gallium selenide were dissolved in hydrazine until a maximum dissoluble amount (also referred to as a dissolution limit) was reached. Specifically, a semiconductor layer forming solution in Comparative Example was prepared so that the total concentration of Cu, In, Ga and Se was 0.5% by mass.

### <(3-1-5) Method for Measuring Particle Diameter>

The average particle diameter of the fine particles and the standard deviation for the particle size distribution thereof in Examples 1 to 10 were measured by performing the following steps (M1) to (M7) in succession.

(M1) A solution to be measured was dripped onto a test substrate to thereby be dried in a vacuum. This provided a condition in which the fine particles were dispersed on the test substrate.

(M2) The fine particles being dispersed on the test substrate were photographed with a SEM, so that a SEM photograph was obtained.

(M3) A transparent film was overlaid on the SEM photograph, and the outer edge geometries of the fine particles were drawn with a pen over the transparent film.

(M4) The transparent film over which the outer edge geometries of the fine particles were drawn was read with a scanner. This provided image data.

(M5) Using predetermined image processing software, the area of a region embracing each of the fine particles was calculated from the image data obtained in the step (M4).

(M6) The particle diameter of each of the fine particles was calculated from the area of each region calculated in the step (M5).

(M7) The average particle diameter of the fine particles captured by the single SEM photograph and the standard deviation for the particle size distribution thereof were calculated from the particle diameters of the respective fine particles calculated in the step (M6).

For the first fine particles and the second fine particles in Examples 11 to 17 and the first fine particles and the second fine particles in Examples 18 to 21, the average particle diameter and the standard deviation for the particle size distribution were also measured by performing steps similar to the aforementioned steps (M1) to (M7) in succession.

### <(3-2) Formation of Semiconductor Layer>

The substrate 1 comprised of glass and comprising a first main surface on which the first and third electrode layers 2 and 6 mainly including Mo were provided was prepared.

The semiconductor layer forming solution in each of Examples 1 to 21 was applied onto the upper surfaces of the first and third electrode layers 2 and 6 and into the gap between the first electrode layer 2 and the third electrode layer 6 by a blade method, and was then dried, whereby a precursor layer having a desired thickness was formed. In this case, the application using the blade method and the drying were repeated twice to form the precursor layer. Next, the precursor layer was subjected to a heat treatment including the steps of: increasing the temperature of the precursor layer from room temperature to approximately 525°C for five minutes; holding the temperature of the precursor layer at approximately 525°C for one hour; and thereafter leaving the precursor layer to cool by itself. This provided a semiconductor layer mainly including CIGS and having a thickness of approximately 2 µm. Thus, a first semiconductor layer in each of Examples 1 to 21 was formed.

Also, the semiconductor layer forming solution in Comparative Example was applied onto the upper surfaces of the first and third electrode layers 2 and 6 and into the gap between the first electrode layer 2 and the third electrode layer 6 by a blade method, and was then dried, whereby a precursor layer was formed. In this case, the application using the blade method and the drying were repeated ten times to form the precursor layer having a desired thickness. Next, the precursor layer was subjected to a heat treatment including the steps of: increasing the temperature of the precursor layer from room temperature to approximately 525°C for five minutes; holding the temperature of the precursor layer at approximately 525°C for one hour; and thereafter leaving the precursor layer to cool by itself. This provided a semiconductor layer mainly including CIGS and having a thickness of approximately 2 µm. Thus, a first semiconductor layer in Comparative Example was formed.

In the semiconductor layer forming solution in each of Examples 1 to 21, the concentration of a starting metallic element was high, and the fine particles were dispersed. The viscosity of the semiconductor layer forming solution was accordingly high. As a result, the semiconductor layer having a desired thickness (in this case, 2 µm) was formed by repeating the application using the blade method and the drying twice.

In the semiconductor layer forming solution in Comparative Example, on the other hand, the concentration of a starting metallic element was low, and the fine particles were not dispersed. The viscosity of the semiconductor layer forming solution was accordingly low. As a result, the formation of the semiconductor layer having a desired thickness (in this case, 2 µm) required repeating the application using the blade method and the drying as many as ten times.

Therefore, the use of the semiconductor layer forming solutions in Examples 1 to 21 achieved the formation of the semiconductor layer having a desired thickness more easily than the use of the semiconductor layer forming solution in Comparative Example.

### <(3-3) Method for Evaluating Semiconductor Layer>

The first semiconductor layer formed using the semiconductor layer forming solution in each of Examples 1 to 21 and Comparative Example was observed for the presence or absence of cracks with an optical microscope and a SEM. Thus, whether the first semiconductor layer was formed well or not was evaluated.

### <(3-4) Production of Photoelectric Conversion Device>

The substrate 1 with the first semiconductor layer in each of Examples 1 to 21 and Comparative Example formed thereon was dipped in a solution prepared by dissolving cadmium acetate and thiourea in ammonia. This formed the second semiconductor layer 4 mainly including CdS and having a thickness of 50 nm on the first semiconductor layer. Next, the second electrode layer 5 was formed on the second semiconductor layer 4 by a sputtering method. The second electrode layer 5 was a transparent film of ZnO doped with Al. Then, an electrode (also referred to as an extraction electrode) including Al was formed by a vapor deposition method. Thus, a photoelectric conversion device in each of Examples 1 to 21 and Comparative Example was produced.

### <(3-5) Method for Evaluating Photoelectric Conversion Device>

The conversion efficiency of the photoelectric conversion device in each of Examples 1 to 21 and Comparative Example was measured with a fixed light solar simulator. Also, the conversion efficiency of the photoelectric conversion device in each of Examples 2, 9 and 11 to 21 and Comparative Example after subjected to a predetermined heat cycle was measured with a fixed light solar simulator. In this case, the conversion efficiency was measured under the conditions that the irradiation intensity of light at a light receiving surface of the photoelectric conversion device was 100 mW/cm² and the air mass (AM) was 1.5.

The predetermined heat cycle used herein was a temperature cycling test defined by JIS (Japanese Industrial Standards) C8917-1998. As the temperature cycling test used herein, one cycle in which temperature was increased, held and decreased within the range of approximately -40°C to approximately 90°C for a time length within six hours was repeated 200 times or more. Specifically, in one cycle, the temperature was increased from room temperature to +90 ± 2°C, then held at +90 ± 2°C for ten minutes or more, next decreased to -40 ± 3°C, thereafter held at -40 ± 3°C for ten minutes or more, and finally increased to room temperature. The rate of temperature increase and the rate of temperature decrease were not more than 87°C/h.

### <(3-6) Result of Observation and Result of Measurement>

### <(3-6-1) Effect Produced by Heating of Starting Solution>

The results of the observation for the presence or absence of cracks in the first semiconductor layer in each of Examples 1 to 10 and Comparative Example, and the results of measurement of the conversion efficiency of the photoelectric conversion device in each of Examples 1 to 10 and Comparative Example were listed in Table 4.

**[Table 4]**

| | Presence or Absence of Cracks | Conversion Efficiency (%) | Comprehensive Evaluation |
|---|---|---|---|
| Example 1 | Absent | 10 | ○ (Very Good) |
| Example 2 | Absent | 11 | ⊚ (Excellent) |
| Example 3 | Absent | 12 | ⊚ (Excellent) |
| Example 4 | Absent | 11 | ⊚ (Excellent) |
| Example 5 | Absent | 12 | ⊚ (Excellent) |
| Example 6 | Absent | 12 | ⊚ (Excellent) |
| Example 7 | Absent | 12 | ⊚ (Excellent) |
| Example 8 | Absent | 12 | ⊚ (Excellent) |
| Example 9 | Absent | 11 | ⊚ (Excellent) |
| Example 10 | Absent | 11 | ○ (Very Good) |
| Comparative Example | Present | 8 | × (Bad) |

The presence of cracks was confirmed in the first semiconductor layer in Comparative Example. On the other hand, the presence of cracks was not confirmed in the first semiconductor layer in each of Examples 1 to 10. In other words, if the heating temperature of the starting solution was in the range of 140 to 210°C, a good first semiconductor layer was formed. From another viewpoint, a good first semiconductor layer was formed if the average particle diameter of the fine particles dispersed in the semiconductor layer forming solution was in the range of 30 to 320 nm.

Also, the conversion efficiency of the photoelectric conversion device in Comparative Example was as low as 8%. On the other hand, if the heating temperature of the starting solution was in the range of 140 to 210°C as in Examples 1 to 10, the conversion efficiency of the photoelectric conversion device was not less than 10%. In this case, if the heating temperature of the starting solution was not less than 140°C, some fine particles were precipitated, and somewhat high conversion efficiency was obtained. Also, if the heating temperature of the starting solution was not more than 210°C, the coating property of the semiconductor layer forming solution was ensured to a certain extent without the precipitation of the fine particles in large amounts in the semiconductor layer forming solution. From another viewpoint, somewhat high conversion efficiency and the insurance of the coating property of the semiconductor layer forming solution to a certain extent were achieved if the average particle diameter of the fine particles dispersed in the semiconductor layer forming solution was in the range of 30 to 300 nm.

Also, if the heating temperature of the starting solution was in the range of 155 to 210°C, the conversion efficiency of the photoelectric conversion device was not less than 11%, so that higher conversion efficiency was obtained. From another viewpoint, high conversion efficiency was obtained if the average particle diameter of the fine particles dispersed in the semiconductor layer forming solution was in the range of 50 to 320 nm.

Also, if the heating temperature of the starting solution was in the range of 140 to 195°C, the fine particles were less prone to be precipitated in the semiconductor layer forming solution, so that the coating property of the semiconductor layer forming solution was excellent. From another viewpoint, the coating property of the semiconductor layer forming solution was excellent if the average particle diameter of the fine particles dispersed in the semiconductor layer forming solution was in the range of 30 to 300 nm.

Therefore, if the heating temperature of the starting solution was in the range of 155 to 195°C as in Examples 2 to 9, high conversion efficiency and the good coating property of the semiconductor layer forming solution were compatible with each other.

### <(3-6-2) Effect Produced by Mixing of Fine Particles Having Different Average Particle Diameters>

The results of the observation for the presence or absence of cracks in the first semiconductor layer in each of Examples 2, 9 and 11 to 17, and Comparative Example, and the results of measurement of the conversion efficiency of the photoelectric conversion device in each of Examples 2, 9 and 11 to 17, and Comparative Example were listed in Table 5.

**[Table 5]**

| | Presence or Absence of Cracks | Conversion Efficiency (%) | Comprehensive Evaluation Before Test | Rate of Decrease in Conversion Efficiency (%) | Comprehensive Evaluation After Test |
|---|---|---|---|---|---|
| Example 11 | Absent | 11 | ⊚ (Excellent) | 48 | Δ (Good) |
| Example 12 | Absent | 12 | ⊚ (Excellent) | 13 | ⊚ (Excellent) |
| Example 13 | Absent | 12 | ⊚ (Excellent) | 8 | ⊚ (Excellent) |
| Example 14 | Absent | 11 | ⊚ (Excellent) | 10 | ⊚ (Excellent) |
| Example 15 | Absent | 11 | ⊚ (Excellent) | 16 | ⊚ (Excellent) |
| Example 16 | Absent | 12 | ⊚ (Excellent) | 35 | ○ (Very Good) |
| Example 17 | Absent | 12 | ○ (Very Good) | 14 | ⊚ (Excellent) |
| Example 2 | Absent | 11 | ⊚ (Excellent) | 50 | Δ (Good) |
| Example 9 | Absent | 11 | ⊚ (Excellent) | 49 | Δ (Good) |
| Comparative Example | Present | 8 | × (Bad) | 95 | × (Bad) |

The presence of cracks was not confirmed in the first semiconductor layer in each of Examples 11 to 17. In other words, if the first heating temperature of the first starting solution was in the range of 120 to 190°C and the second heating temperature of the second starting solution was in the range of 195 to 210°C, a good first semiconductor layer was formed.

Also, if the first heating temperature of the first starting solution was in the range of 120 to 190°C and the second heating temperature of the second starting solution was in the range of 195 to 210°C, the conversion efficiency of the photoelectric conversion device prior to the temperature cycling test was as high as not less than 11%. At this time, the second average particle diameter of the second fine particles produced in the second starting solution was in the range of 300 to 320 nm.

However, the conversion efficiency of the photoelectric conversion device in each of Examples 2, 9 and 11 was decreased to approximately half by the temperature cycling test. Additionally, the conversion efficiency of the photoelectric conversion device in Comparative Example was decreased by 95% by the temperature cycling test. In other words, the photoelectric conversion device in Comparative Example was significantly poor in durability.

In contrast to this, the conversion efficiency of the photoelectric conversion device in each of Examples 12 to 17 was not decreased to half by the temperature cycling test. In other words, if the first heating temperature of the first starting solution was in the range of 140 to 190°C, the value (the average particle diameter ratio) obtained by dividing the second average particle diameter by the first average particle diameter was in the range of 1.5 to 11, so that the photoelectric conversion device having high conversion efficiency and somewhat excellent durability was provided.

Also, the rate of decrease in the conversion efficiency of the photoelectric conversion device in each of Examples 12 to 15 and 17 due to the temperature cycling test was in the range of 8 to 16%. In other words, if the first heating temperature of the first starting solution was in the range of 140 to 180°C, the value (the average particle diameter ratio) obtained by dividing the second average particle diameter by the first average particle diameter was in the range of 3 to 11, so that the photoelectric conversion device having high conversion efficiency and excellent durability was provided. In this case, the durability of the first semiconductor layer was improved by the densification of the first semiconductor layer.

Precipitates including the second fine particles were prone to be formed in the second intermediate solution in Example 17. Thus, if the first heating temperature of the first starting solution was in the range of 140° to 190°C and the second heating temperature of the second starting solution was approximately 195°C, the fine particles were less prone to be precipitated in the semiconductor layer forming solution, so that the coating property of the semiconductor layer forming solution was excellent.

Thus, if the value (the average particle diameter ratio) obtained by dividing the second average particle diameter by the first average particle diameter was in the range of 3 to 10, the coating property of the semiconductor layer forming solution was excellent and the photoelectric conversion device which had high conversion efficiency and excellent durability was provided.

### <(3-6-3) Effect Produced by Particle Size Distribution of Fine Particles>

The results of the observation for the presence or absence of cracks in the first semiconductor layer in each of Examples 2, 9 and 18 to 21, and Comparative Example, and the results of measurement of the conversion efficiency of the photoelectric conversion device in each of Examples 2, 9 and 18 to 21, and Comparative Example were listed in Table 6.

**[Table 6]**

| | Presence or Absence of Cracks | Conversion Efficiency (%) | Comprehensive Evaluation Before Test | Rate of Decrease in Conversion Efficiency (%) | Comprehensive Evaluation After Test |
|---|---|---|---|---|---|
| Example 18 | Absent | 12 | ⊚ (Excellent) | 20 | ⊚ (Excellent) |
| Example 19 | Absent | 12 | ⊚ (Excellent) | 10 | ⊚ (Excellent) |
| Example 20 | Absent | 11 | ⊚ (Excellent) | 15 | ⊚ (Excellent) |
| Example 21 | Absent | 11 | ○ (Very Good) | 14 | ⊚ (Excellent) |
| Example 2 | Absent | 11 | ⊚ (Excellent) | 50 | Δ (Good) |
| Example 9 | Absent | 11 | ⊚ (Excellent) | 49 | Δ (Good) |
| Comparative Example | Present | 8 | × (Bad) | 95 | × (Bad) |

The presence of cracks was not confirmed in the first semiconductor layer in each of Examples 18 to 21. Thus, if the first heating temperature of the starting solution was approximately 155°C and the second heating temperature of the intermediate solution was in the range of 180 to 210°C, a good first semiconductor layer was formed.

Also, if the first heating temperature of the starting solution was approximately 155°C and the second heating temperature of the intermediate solution was in the range of 180 to 210°C, the conversion efficiency of the photoelectric conversion device prior to the temperature cycling test was as high as not less than 11 %. At this time, the first average particle diameter of the first fine particles produced by the heating of the starting solution at the first heating temperature was approximately 50 nm, and the second average particle diameter of the second fine particles produced by the heating of the intermediate solution at the second heating temperature was in the range of 250 to 350 nm. The first standard deviation for the particle size distribution of the first fine particles was 5 nm, and the second standard deviation for the particle size distribution of the second fine particles was in the range of 15 to 35 nm.

On the other hand, the conversion efficiency of the photoelectric conversion device in each of Examples 2 and 9 was decreased to approximately half by the temperature cycling test. Additionally, the conversion efficiency of the photoelectric conversion device in Comparative Example was decreased by 95% by the temperature cycling test. In other words, the photoelectric conversion device in Comparative Example was significantly poor in durability.

In contrast to this, the conversion efficiency of the photoelectric conversion device in each of Examples 18 to 21 was decreased only by on the order of 10 to 20% by the temperature cycling test. Thus, if the second standard deviation was in the range of 15 to 35 nm, the photoelectric conversion device having high conversion efficiency and excellent durability was provided. In this case, the durability of the first semiconductor layer was improved by the densification of the first semiconductor layer.

Precipitates including the second fine particles were prone to be formed in the semiconductor layer forming solution in Example 21. Thus, if the second heating temperature was in the range of 180 to 200°C, the second fine particles were less prone to be precipitated in the semiconductor layer forming solution, so that the coating property of the semiconductor layer forming solution was excellent. At this time, the second standard deviation was in the range of 15 to 30 nm, and the second average particle diameter was in the range of 250 to 320 nm.

### <(4) Modifications>

The present invention is not limited to the aforementioned embodiment, but various modifications may be made therein without departing from the spirit and scope of the present invention.

For example, the photoelectric conversion device may include no buffer layer, and the second electrode layer 5 may be a semiconductor layer of a conductivity type (for example, an n-type) different from that of the first semiconductor layer 3.

Also, the photoelectric conversion device may include no collecting electrodes 8.

In the aforementioned embodiment, the first and third electrode layers 2 and 6 are in the form of a layer, but are not limited to this. For example, the first and third electrode layers 2 and 6 may be an electrode section (also referred to as a first electrode section) having other forms such as a grid form.

Also, the photoelectric conversion device may include no second electrode layer 5, and the collecting electrodes 8 may be provided on the second semiconductor layer 4.

Thus, the photoelectric conversion device is required only to be configured, for example, such that a second layer including the first semiconductor layer 3 is formed on a first layer including the first electrode section, and such that a third layer including at least one electrode section (also referred to as a second electrode section) selected from among the second electrode layer 5 and the collecting electrodes 8 is formed on the second layer.

A configuration can be contemplated in which the starting solution is not included in the semiconductor layer forming solution.

In the aforementioned embodiment, a configuration can be contemplated in which, for example, the intermediate solution including the first fine particles does not include the starting solution in the third method for producing the semiconductor layer forming solution. Further, the first fine particles which are not included in a solution may be heated, so that the second fine particles are formed by particle growth resulting from the coupling of the fine particles and the like.

A semiconductor layer other than the first semiconductor layer 3 may be formed using the semiconductor layer forming solution.

It goes without saying that all or some parts constituting the aforementioned embodiment and various modifications may be consistently combined, as appropriate.

### Description of Symbols

- 1: Substrate
- 2: First electrode layer
- 3: First semiconductor layer
- 4: Second semiconductor layer
- 5: Second electrode layer
- 6: Third electrode layer
- 7: Connection conductor
- 8: Collecting electrodes
- 10: Photoelectric conversion device
- 100: Photoelectric conversion module

## Claims

1. A method for manufacturing a semiconductor layer, comprising the steps of:
(a) producing a starting solution including a metallic element, an organic compound containing a chalcogen element, and a Lewis base organic compound;
(b) producing fine particles containing a metal chalcogenide which is a compound of the metallic element and a chalcogen element included in the organic compound containing a chalcogen element by heating the starting solution; and
(c) forming a semiconductor layer by using a semiconductor layer forming solution in which the fine particles are dispersed.

2. The method for manufacturing a semiconductor layer according to claim 1, wherein the semiconductor layer forming solution further includes the starting solution.

3. The method for manufacturing a semiconductor layer according to claim 1 or 2,
wherein the step (b) includes the steps of: (b-1) heating the starting solution at a first temperature to produce first fine particles containing the metal chalcogenide; and (b-2) heating the first fine particles at a second temperature higher than the first temperature to produce second fine particles containing the metal chalcogenide,
wherein a second standard deviation about a particle size distribution of the second fine particles is greater than a first standard deviation about a particle size distribution of the first fine particles, and
wherein the fine particles dispersed in the semiconductor layer forming solution include the second fine particles.

4. The method for manufacturing a semiconductor layer according to claim 3, wherein the second standard deviation is in the range of 15 to 30 nm.

5. The method for manufacturing a semiconductor layer according to claim 1 or 2,
wherein the starting solution includes a first starting solution and a second starting solution,
wherein the step (b) includes the steps of: (b-1) heating the first starting solution at a first temperature to produce first fine particles containing the metal chalcogenide; and (b-2) heating the second starting solution at a second temperature higher than the first temperature to produce second fine particles containing the metal chalcogenide,
wherein each of the first starting solution and the second starting solution contains a metallic element, an organic compound containing a chalcogen element, and a Lewis base organic compound,
wherein a second average particle diameter of the second fine particles is greater than a first average particle diameter of the first fine particles, and
wherein the fine particles dispersed in the semiconductor layer forming solution include the first fine particles and the second fine particles.

6. The method for manufacturing a semiconductor layer according to claim 5, wherein the second average particle diameter is three to ten times the first average particle diameter.

7. The method for manufacturing a semiconductor layer according to any one of claims 1 to 6,
wherein the metallic element includes a group IB element and a group IIIB element, and
wherein the semiconductor layer includes a group I-III-VI compound semiconductor.

8. The method for manufacturing a semiconductor layer according to any one of claims 1 to 7, wherein the average particle diameter of the fine particles is less than or equal to 1 µm.

9. The method for manufacturing a semiconductor layer according to any one of claims 1 to 8, further comprising the step of
(d) dispersing the fine particles produced in the step (b) in a solution containing the metallic element, the organic compound containing a chalcogen element and the Lewis base organic compound to produce the semiconductor layer forming solution.

10. The method for manufacturing a semiconductor layer according to any one of claims 1 to 9, wherein the heating temperature of the starting solution in the step (b) is in the range of 155 to 195°C.

11. The method for manufacturing a semiconductor layer according to any one of claims 1 to 10, wherein the metallic element in at least one state selected from among the state of a single element and the state of an alloy is dissolved in a mixed solvent including the organic compound containing a chalcogen element and the Lewis base organic compound in the step (a).

12. The method for manufacturing a semiconductor layer according to any one of claims 1 to 11, wherein the composition of the fine particles and the composition of the semiconductor layer are identical with each other.

13. A method for manufacturing a photoelectric conversion device, comprising the steps of:
(A) forming a second layer on a first layer; and
(B) forming a third layer on the second layer,
wherein a semiconductor layer included in the second layer is formed in the step (A) by a method for producing a semiconductor layer as recited in any one of claims 1 to 12,
wherein the first layer includes a first electrode section, and
wherein the third layer includes a second electrode section.

14. A semiconductor layer forming solution comprising a metallic element, an organic compound containing a chalcogen element, and a Lewis base organic compound, the semiconductor layer forming solution further comprising fine particles containing a metal chalcogenide which is a compound of the metallic element and a chalcogen element included in the organic compound containing a chalcogen element,
wherein the fine particles being dispersed in the semiconductor layer forming solution.
